# EUROPEAN PATENT APPLICATION

(11) **EP 1 367 641 A1**
(43) Date of publication of application: **03.12.2003**
(21) Application number: 02011781.8
(22) Date of filing: 27.05.2002
(51) Int. Cl.: H01L 23/367, H01L 23/427, H01L 23/467

(54) **Heat radiator**

(71) Applicant: Wang, Chin-Wen, Ping Jen City, Tao Yuan, Hsien (TW); Wang, Pei-Choa, Ping Jen City, Tao Yuan Hsien (TW); Wang, Ching Chung, Ping Jen City, Tao Yuan Hsien (TW)
(72) Inventor: Wang, Chin-Wen, Ping Jen City, Tao Yuan, Hsien (TW); Wang, Pei-Choa, Ping Jen City, Tao Yuan Hsien (TW); Wang, Ching Chung, Ping Jen City, Tao Yuan Hsien (TW)
(74) Representative: Viering, Jentschura & Partner

(57) **Abstract**

The present invention provides a heat radiator, which comprises an outer ring heat spreader, a plurality of outer heat-spreading fins, and a plurality of inner heat-radiating fins. The outer ring heat spreader has a seat bottom face and an annular wall. The inside of the annular wall has a receiving space. The outer heat-radiating fins are disposed outside the outer ring heat spreader, and project from the outer wall of the outer ring heat spreader and radially scatter outwards. The inner heat-radiating fins are disposed inside the receiving space of the outer ring heat spreader, and radially gather together toward the center of the outer rung heat spreader. A cavity is disposed inside the outer ring heat spreader to receive cooling liquid and a heat pipe. A heat radiator capable of enhancing the heat-spreading and cooling functions and having a better heat-radiating effect is thus formed.

## Description

### Field of the invention

The present invention relates to a heat radiator and, more particularly, to a heat radiator, wherein outer and inner heat-radiating fins thereof are used together, and a cavity for receiving cooling liquid is also matched to achieve a better heat-radiating effect through convective characteristic of liquid and air.

### Background of the invention

Nowadays, every aspect of lives cannot come off the range of scientific technology. Scientific progress mainly shows in the invention of computer. Especially, the influence of central processing unit (CPU) in the computer has already totally permeated personal life.

Along with quick development of the computer industry, computers have more and more powerful operational capacity, and the operational speeds of CPUs become faster and faster. Moreover, the CPUs give out more and more heat. In order to let the CPUs operate under admissible temperatures, various kinds of heat radiators having increased heat-radiating areas have been proposed to apply to electronic parts giving out more heat like the CPUs.

However, the heat-radiating function of conventional heat-radiating fins can hardly solve the heat-radiating problem of heat source generated when the CPU operates with the operational speed thereof enhanced more and more.

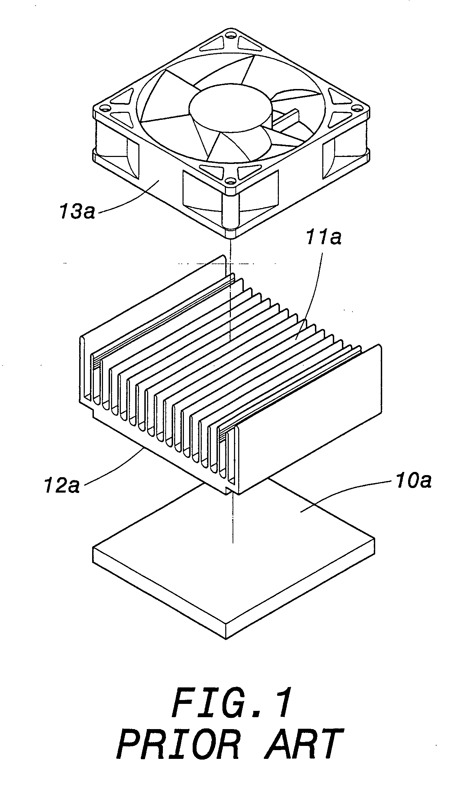

As shown in Fig. 1, in a prior art desktop computer, a CPU 10a generally adopts a plurality of open-end erect heat-radiating fins 11a as the heat radiator. Heat source generated by the CPU 10a in the computer is spread from a bottom face 12a to the heat-radiating fins 11a. A fan 13a is also matched to radiate out heat.

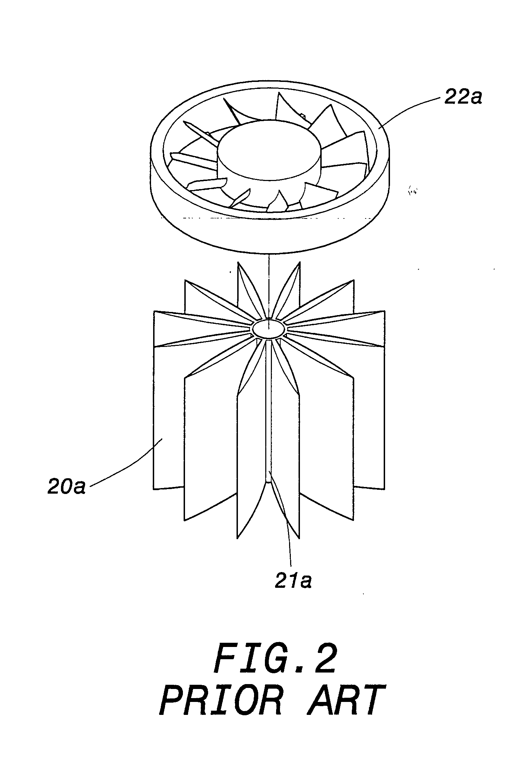

As shown in Fig. 2, a plurality of heat-radiating fins 20a are circularly distributed with a central cylinder heat spreader 21a as the center. A fan 22a is also matched to accomplish the whole heat-radiating function.

However, the above prior art heat radiators need a fan to radiate out heat so as to achieve a certain heat-radiating effect. Because of the disposition of fan, more space is occupied, and the cost is also increased.

Moreover, because the one side of the above heat-radiating fins opposite to the fan is a closed plane, the heat-radiating capacity in limited space is much restrained. Moreover, the prior art open-end heat-radiating fins are solid material, which spreads heat by means of heat conduction. Therefore, the heat-radiating speed is much slower than the speed at which heat is discharged by means of heat convection when the CPU operates. The heat-radiating efficiency thereof is thus not good enough.

Accordingly, the above heat radiators have inconvenience and drawbacks in practical use. The present invention aims to provide a heat radiator to resolve the problems in the prior art.

### Summary of the invention

The primary object of the present invention is to provide a heat radiator, wherein outer and inner heat-radiating fins are used together to greatly increase the heat-radiating area and enhance the heat-spreading and cooling functions, thereby achieving a better heat-radiating effect.

Another object of the present invention is to provide a heat radiator with a cavity disposed therein for receiving cooling liquid so as to have circulatory function of heat convection. A better heat-radiating effect can be achieved through convective characteristic of liquid and air. A heat pipe surrounding the inner heat-radiating fins is also provided for quickly spreading heat, thereby enhancing the heat-absorbing capacity and speed of the cooling liquid.

To achieve the above objects, the present invention provides a heat radiator, which comprises an outer ring heat spreader having an annular wall, a plurality of outer heat-spreading fins, and a plurality of inner heat-radiating fins. The inside of the annular wall has a receiving space. The outer heat-radiating fins are disposed outside the outer ring heat spreader. The inner heat-radiating fins are disposed inside the receiving space of the outer ring heat spreader. A heat radiator having a better heat-radiating effect is thus formed.

The various objects and advantages of the present invention will be more readily understood from the following detailed description when read in conjunction with the appended drawing, in which:

### Brief description of the drawings:

Fig. 1 is a perspective view of a heat radiator in the prior art;
Fig. 2 is a perspective view of another kind of heat radiator in the prior art;
Fig. 3 is an exploded perspective view according to a first embodiment of the present invention;
Fig. 4 is a perspective assembly view according to the first embodiment of the present invention;
Fig. 5 is a longitudinal cross-sectional view according to the first embodiment of the present invention;
Fig. 6 is a transversal cross-sectional view according to the first embodiment of the present invention;

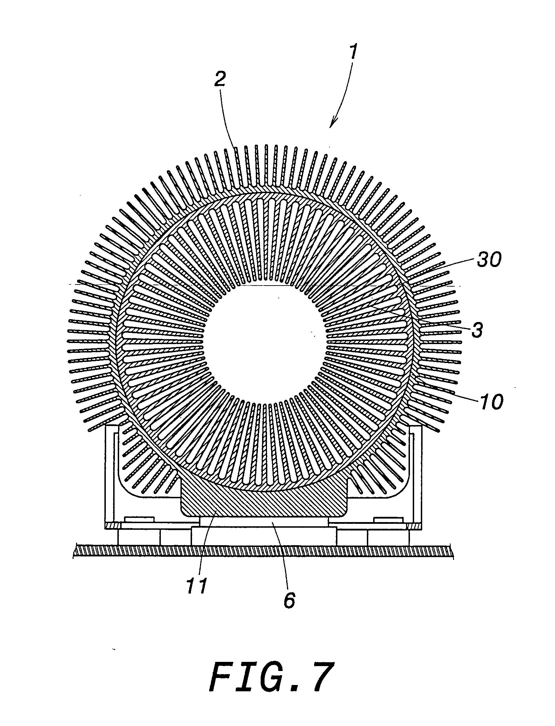

Fig. 7 is a transversal cross-sectional view according to a second embodiment of the present invention;
Fig. 8 is an exploded perspective view according to a third embodiment of the present invention;
Fig. 9 is a longitudinal cross-sectional view according to the third embodiment of the present invention; and
Fig. 10 is a transversal cross-sectional view according to the third embodiment of the present invention;

### Detailed description of the preferred embodiments

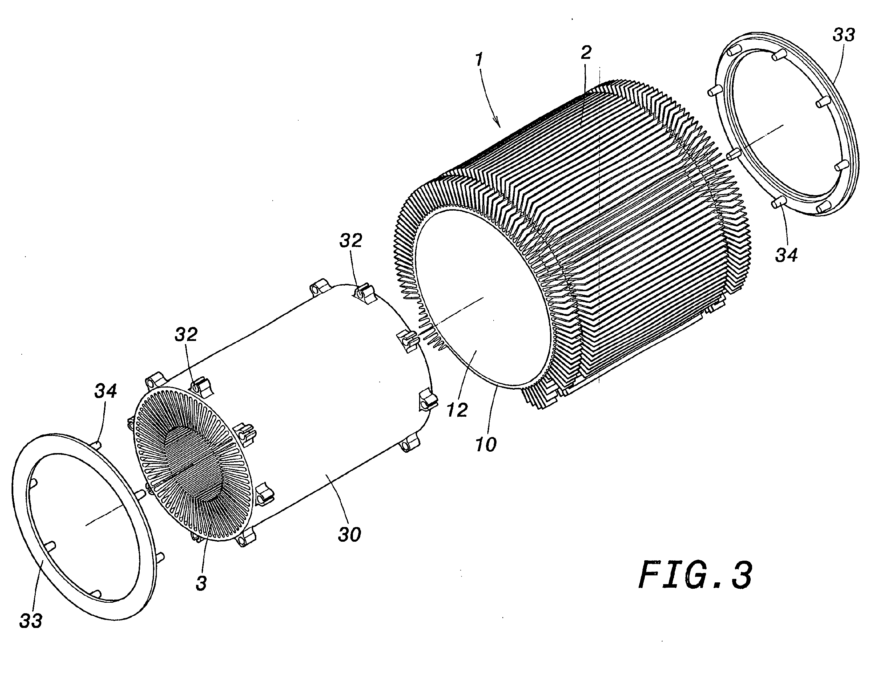

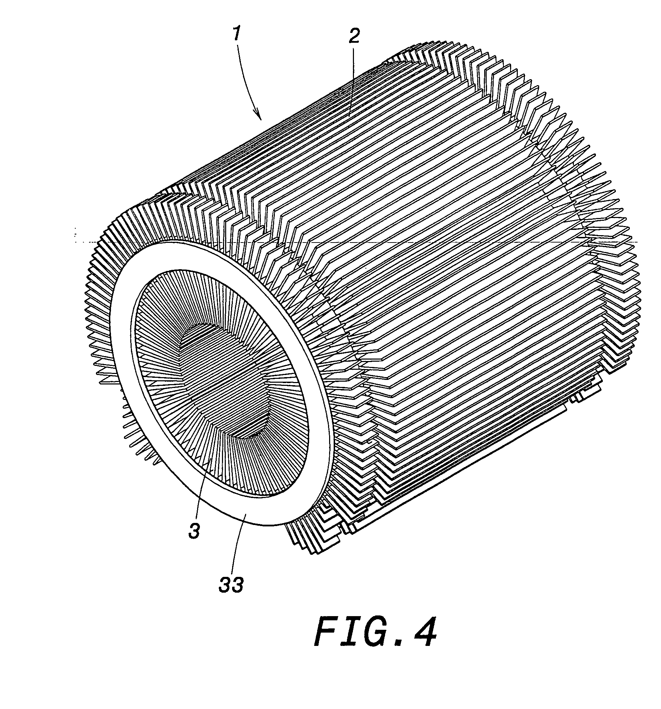

As shown in Figs. 3, 4, 5, and 6, the present invention provides a heat radiator comprising an outer ring heat spreader 1, a plurality of outer heat-radiating fins 2, and a plurality of inner heat-radiating fins 3. The inner and outer heat-radiating fins 2 and 3 are used together and are situated above a CPU 6. Circulation of cooling liquid can be formed therein to radiate out heat source generated when the CPU 6 operates.

The outer ring heat spreader 1 is made of material of good heat conductance, and comprises a seat bottom face 11 and an annular wall 10. The annular wall 10 is formed of a cylindrical ring. The seat bottom face 11 is integrally formed and connected at the outside of the annular wall 10. The inside of the annular wall 10 has a hollow receiving space, which penetrates to two ends of the outer ring heat spreader 1.

The outer heat-radiating fins 2 are disposed outside the outer ring heat spreader 1. The outer heat-radiating fins 2 project from the outer wall of the outer ring heat spreader 1, and radially scatter outwards. The outer heat-radiating fins 2 are made of material with good heat conductance, and are integrally formed outside the outer ring heat spreader 1, or are assembled outside the outer ring heat spreader 1.

The inner heat-radiating fins 3 are disposed inside the receiving space 12 of the outer ring heat spreader 1. The inner heat-radiating fins 3 radially gather together toward the center of the outer ring heat spreader 1. The inner heat-radiating fins 3 are made of material with good heat conductance, and are integrally formed inside the receiving space 12 of the outer ring heat spreader 1 (i.e., directly project from the inner wall of the outer ring heat spreader 1), or are assembled inside the outer ring heat spreader 1.

If the inner heat-radiating fins 3 are assembled inside the outer ring heat spreader 1, the inner heat-radiating fins 3 must be formed inside an inner ring heat spreader 30 in advance, and the inner ring heat spreader 30 and the inner heat-radiating fins 3 are then assembled inside the receiving space 12. An annular cavity 31 can be formed between the inner ring heat spreader 30 and the outer ring heat spreader 1. Cooling liquid can be received in the cavity 31 to enhance the heat-spreading and cooling functions of the heat radiator.

A predetermined space can also be formed inside the inner heat-radiating fins 3 so that a pump or a heat pipe (not shown) can be installed therein according to necessity. An inbuilt pump or an external pump or heat pipe can be used to drive the cooling liquid in the cavity 31 to make circulative flow, thereby achieving a better heat-radiating effect.

A plurality of retaining holes 32 are disposed on the outer wall of the inner ring heat spreader 30. A ring-shaped cover 33 is disposed at each end of the cavity 31. A plurality of retaining posts 34 corresponding to the retaining holes 32 are disposed on the cover 33. The retaining posts 34 can be retained with the retaining holes 32 so that the two covers 33 can be retained with the two ends of the cavity 31, hence closing the two ends of the cavity 31. Of course, the two covers 33 are not limited to being connected at the two ends of the cavity 31 in retaining way. The two covers 33 can also be connected at the two ends of the cavity 31 in screwing or soldering way. A heat radiator of the present invention is thus formed.

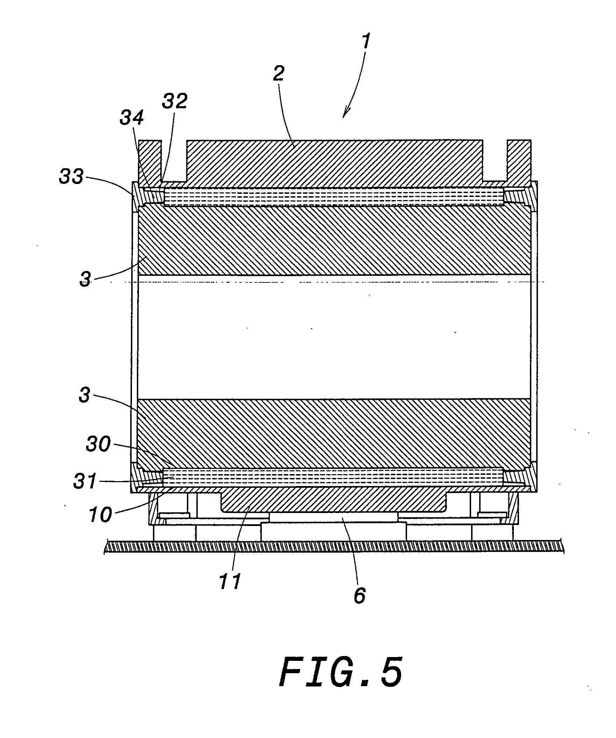

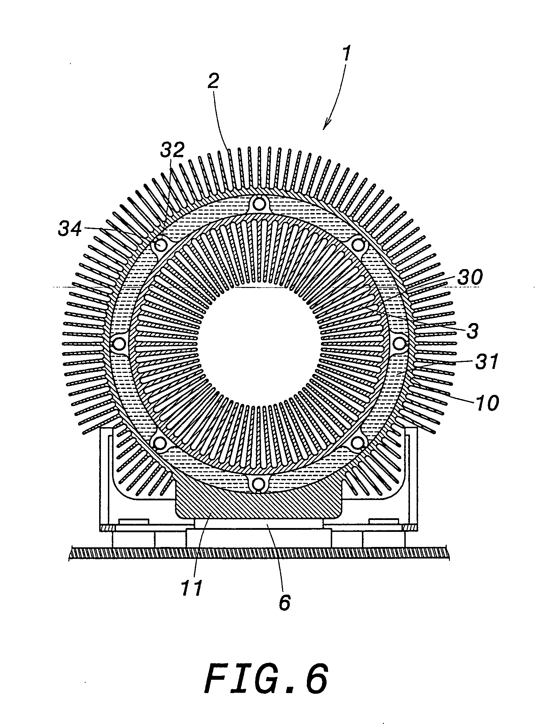

As shown in Figs. 5 and 6, the seat bottom face 11 of the outer ring heat spreader 1 of the present invention can be placed on the CPU 6 to transmit heat source generated when the CPU operates to the outer ring heat spreader 1, the outer heat-radiating fins 2, and the inner heat-radiating fins 3. The present invention is characterized in that the inner and outer heat-radiating fins 2 and 3 are used together to greatly increase heat-radiating area and enhance heat-spreading and cooling functions.

Moreover, the cavity 31 is disposed inside the outer ring heat spreader 1 to receive cooling liquid. When the heat source generated by the CPU 6 is transmitted from the outer ring heat spreader 1 to the cooling liquid, the heat source can be quickly transferred. Residual heat will be spread into the outer and inner heat-radiating fins 2 and 3 by means of convective circulation to achieve a better heat-radiating effect. In other words, the present invention utilizes the convective characteristic of liquid and air to achieve a better heat-radiating effect.

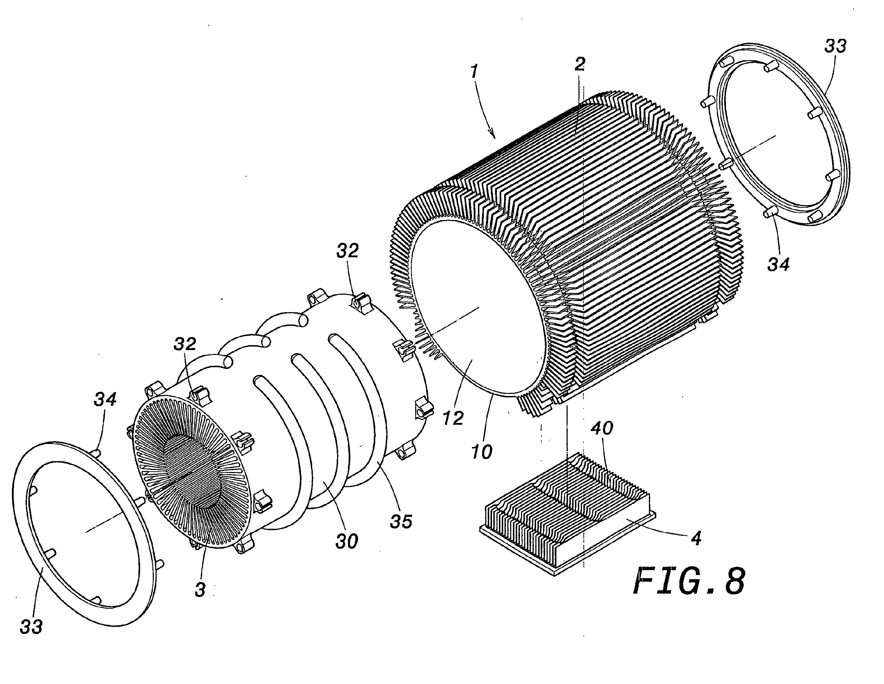

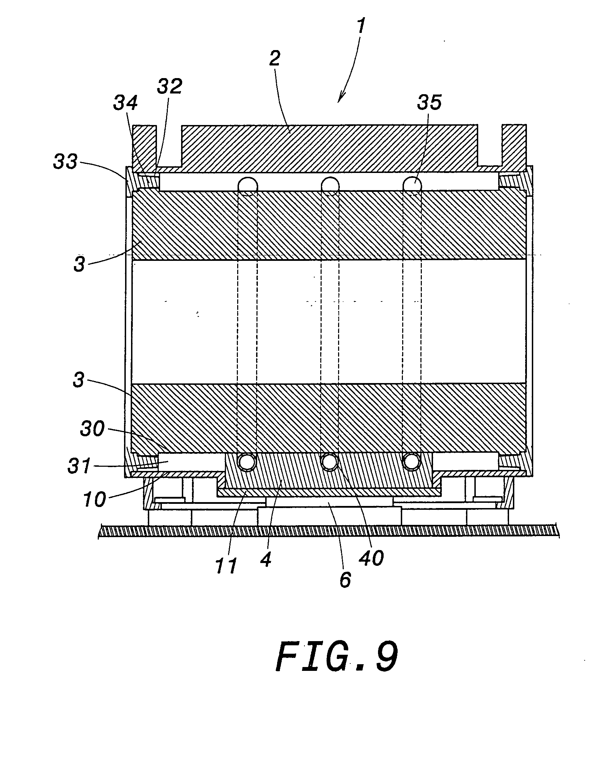

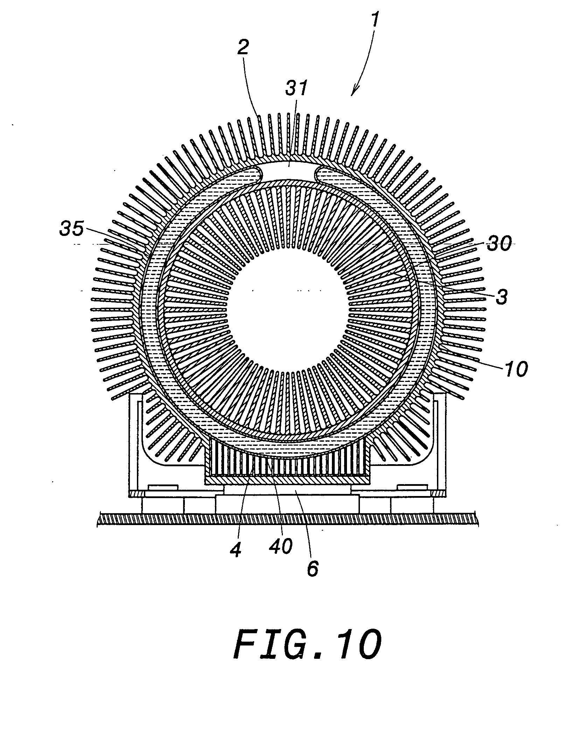

Additionally, as shown in Figs. 8, 9, and 10, a heat pipe 35 can also be disposed in the cavity 31. The heat pipe 35 surrounds the inner ring heat spreader 30 of the inner heat-radiating fins 3. Heat-spreading fins 4 are also disposed outside the inner ring heat spreader 30. The heat-spreading fins 4 can be connected with the CPU. A fixing groove 40 is also disposed on the heat-spreading fins 4 to fix the heat pipe 35. Through quick transmission of heat of the heat pipe 35, the heat-absorbing capacity and speed of the cooling liquid can be enhanced.

Although the present invention has been described with reference to the preferred embodiment thereof, it will be understood that the invention is not limited to the details thereof. Various substitutions and modifications have been suggested in the foregoing description, and other will occur to those of ordinary skill in the art. Therefore, all such substitutions and modifications are intended to be embraced within the scope of the invention as defined in the appended claims.

## Claims

1. A heat radiator, comprising:
an outer ring heat spreader having an annular wall, said annular wall having a receiving space therein;
a plurality of outer heat-radiating fins disposed outside said outer ring heat spreader; and
a plurality of inner heat-radiating fins disposed inside said receiving space of said outer ring heat spreader.

2. The heat radiator as claimed in claim 1, wherein a seat bottom face is connected at the outside of said annular wall of said outer ring heat spreader.

3. The heat radiator as claimed in claim 1, wherein a cavity is disposed inside said outer ring heat spreader for receiving cooling liquid.

4. The heat radiator as claimed in claim 1, wherein said outer heat-radiating fins project from an outer wall of said outer ring heat spreader, and radially scatter outwards.

5. The heat radiator as claimed in claim 1, wherein said inner heat-radiating fins radially gather together toward a center of said outer ring heat spreader.

6. The heat radiator as claimed in claim 1, wherein said inner heat-radiating fins are integrally formed inside said receiving space of said outer ring heat spreader, and project from an inner wall of said outer ring heat spreader.

7. The heat radiator as claimed in claim 1, wherein said inner heat-radiating fins are assembled in said outer ring heat spreader.

8. The heat radiator as claimed in claim 7, wherein said inner heat-radiating fins are formed inside an inner ring heat spreader, and said inner ring heat spreader and said inner heat-radiating fins are then assembled inside said receiving space.

9. The heat radiator as claimed in claim 8, wherein a cavity is formed between said inner ring heat spreader and said outer ring heat spreader to receive cooling liquid.

10. The heat radiator as claimed in claim 9, wherein a plurality of retaining holes are disposed on an outer wall of said inner ring heat spreader, a cover is disposed at each end of said cavity, and a plurality of retaining posts retained with said retaining holes are disposed on said covers so that said two covers can be retained at the two ends of said cavity to close the two ends of said cavity.

11. The heat radiator as claimed in claim 9, wherein a heat pipe is disposed in said cavity to enhance the heat-absorbing capacity and speed of the cooling liquid.
